# EUROPEAN PATENT SPECIFICATION

(11) **EP 4 723 252 B1**
(45) Date of publication and mention of the grant of the patent: **29.07.2026**
(21) Application number: 24203796.8
(22) Date of filing: 01.10.2024
(51) Int. Cl.: H01M 8/04537, C25B 9/70, C25B 9/73, C25B 15/023, H01M 8/0202, H01M 10/42

(54) **CELL VOLTAGE PICKUP SUB-ASSEMBLY AND ASSEMBLY FOR FUEL CELL AND ELECTROLYZER STACK VOLTAGE MONITORING**
ZELLSPANNUNGSERFASSUNGSBAUGRUPPE UND BAUGRUPPE ZUR BRENNSTOFFZELLEN- UND ELEKTROLYSEURSTAPELSPANNUNGSÜBERWACHUNG
SOUS-ENSEMBLE DE CAPTURE DE TENSION DE CELLULE ET ENSEMBLE POUR LA SURVEILLANCE DE TENSION D'EMPILEMENT DE PILES À COMBUSTIBLE ET D'ÉLECTROLYSEUR

(43) Date of publication of application: 08.04.2026
(73) Proprietor: AVL List GmbH, 8020 Graz (AT); AVL Fuel Cell Canada Inc, Burnaby, British Columbia V5A 4W2 (CA)
(72) Inventor: Mann, Bhagwant Tejpaul, 5980 Burnaby (CA)
(74) Representative: Gamper, Bettina

(56) References cited:
- WO-A1-2023/231248
- KR-A- 20110 050 026
- KR-A- 20240 015 771
- KR-B1- 101 821 748

## Description

The present invention is related to a cell voltage pickup (CVP) sub-assembly, a CVP assembly comprising such a CVP sub-assembly and a fuel cell or electrolyzer system.

A CVP assembly typically provides a multichannel interface between a fuel cell or electrolyzer stack and a cell voltage monitoring (CVM) system to measure voltages of individual cells or groups of cells. A typical CVP assembly consist of one or more CVP sub-assemblies and a mounting system. CVP assemblies can be used to monitor the health of fuel cell or electrolyzer stacks in various applications including, but not limited to, stationary power, laboratory, transportation, automotive, trucking, marine, railway, and aviation.

There are many design considerations and challenges for CVP assemblies as performance and pollution degree requirements can vary for different applications. CVP assemblies typically require application-specific custom solutions since off-the-shelf solutions are typically not available. Pick-ups of the CVP sub-assemblies must maintain a good and robust electrical connection to the unit cells and to the PCB itself. Therefore, mating features in the unit cells must thus be considered early in the design process of the CVP assembly. Design considerations for CVP assemblies include, but not limited to, stack length, cell pitch (distance between adjacent cells), altitude, pollution degree, mechanical shock, vibration, voltage range, and the measurement interval. Currently, there are no known off-the-shelf solutions for a CVP assembly that are simply adaptable to different stack lengths, cell-to-cell length variations, and operating in automotive shock and vibration environment, for example.

Further CVP sub-assemblies are for example shown in KR 2011 0050026 A and WO 2023/231248 A1.

It is an objective of the present invention to overcome the disadvantages described above, at least partly. In particular, it is an objective of the present invention to provide a solution to reliably convey cell voltages from a fuel cell or electrolyzer stack to a CVM system in real-time while allowing adjustability, scalability, and robustness to harsh environments, including automotive shock and vibration, for example.

The aforementioned deficiencies are solved by a CVP sub-assembly with the features of claim 1, a CVP assembly with the features of claim 8, a fuel cell or electrolyzer system with the features of claim 14. Further features and details of the invention result from the subclaims, the description, and the figures. Features and details described in connection with the CVP sub-assembly according to the invention naturally also apply to the CVP assembly according to the invention, to the fuel cell or electrolyzer system according to the invention.

According to the present invention, a CVP sub-assembly for conveying cell voltages to a cell voltage monitoring (CVM) system is described. The CVP sub-assembly comprises a printed circuit board (PCB) for conducting electricity, at least one electrical contact (pick-up) for electrically connecting at least one of the unit cells of a fuel cell or electrolyzer stack and the PCB. The CVP sub-assembly further comprises a carrier bracket for holding the PCB, wherein the carrier bracket comprises at least one through hole for mounting to a glide rod.

One advantage of the CVP sub-assembly, according to the invention, is that cell voltages can be reliably conveyed to the CVM system in applications where significant mechanical shock and vibration loads are present. Furthermore, the cell voltage measurements of varying stack lengths and at various pick-up positions along the stacking length of the fuel cell or electrolyzer stack are possible with the CVP sub-assembly according to the invention.

The CVP sub-assembly can comprise a carrier bracket and a CVP unit. The CVP unit can comprise a PCB and at least one electrical contact (pick-up). The CVP unit can further comprise a means of communicating at least one cell voltage to a CVM system.

A unit cell block of a fuel cell or electrolyzer stack comprises one or more unit cells, as described in subsequent paragraphs.

One or more CVP units can collect the cell voltages of a unit cell block of a fuel cell or electrolyzer stack. The unit cell block comprises several electrochemical unit cells that are physically arranged in series such that their largest faces, by surface area, are in contact with one another. The unit cell block can comprise fuel cells or electrolysers based on Proton Exchange Membrane (PEM) technology, Solid Oxide Cell (SOC) technology, or other competing technologies.

The at least one pick-up can conduct electricity from the unit cell to the PCB. Further, the at least one pick-up can be flexible. Furthermore, the at least one pick-up can be based on a spring wire. There are various possible geometries for the at least one pick-up to allow the CVP sub-assembly to mount to the stack in different orientations. Pick-up designs described herein are examples of possible electrical contacts. The shape of the pick-ups can be designed to suit any application.

The CVP unit can comprise several pick-ups. The flexible pick-ups are designed to compensate for the unit cell block length change over time due to compression set of seals and gas diffusion layers, as well as stack length changes arising from cell-to-cell variations and/or stack configuration based on power requirements.

In one instance, the CVP unit can comprise an electrical connector for communicating cell voltages to the CVM system. In another instance, the CVP unit may eliminate the electrical connector by incorporating a flexible circuit (thereby comprising a "rigid-flex printed circuit board"). Because the electrical connector is eliminated in the rigid-flex printed circuit board, the robustness of the CVP unit can be greatly improved in harsh environments.

According to an aspect of the CVP sub-assembly, the at least one pick-up is looped through and/or inserted into two adjacent holes of the PCB for optimal geometric alignment and, after soldering, to provide a secure electromechanical connection and for maximal robustness against mechanical loading. In one instance, the at least one pick-up can be looped through a first hole of the PCB from a PCB front side to a PCB back side and then the at least one pick-up can be looped through a second hole of the PCB from the PCB back side to the PCB front side. In another instance, with one open-ended hole of the PCB, the at least one pick-up can simply be placed into position without the need for articulation of the pick-up; this instance is ideally suited for automated machine assembly using pick-and-place methodology.

According to a further aspect of the CVP sub-assembly, the at least one pick-up is soldered to the PCB using four soldering points to maximize robustness against mechanical loading. The first and second soldering points can be the areas where the at least one pick-up intersects with the front side of the PCB, the third and fourth soldering points can be the areas where the at least one pick-up intersects the back side of the PCB.

The CVP assembly comprises at least one glide rod. The glide rod can extend through at least one hole of the carrier bracket to hold the carrier bracket. The carrier bracket can comprise several through-holes wherein each through-hole can be used for mounting to a glide rod. Further, the CVP assembly can comprise multiple glide rods, depending on the application needs.

The carrier bracket comprises at least one retaining mechanism for retaining the position of the carrier bracket to the at least one glide rod. In one instance, the retaining mechanism can comprise a screw. With the screw, the diameter of the at least one through-hole can be reduced to secure the carrier bracket to the glide rod. In another instance, the retaining mechanism can comprise a spring-loaded lever that mates with elements of the glide rod to secure the carrier bracket to the glide rod. In yet another instance, the retaining mechanism can comprise at least one spring clamp that, when released, clamps to the glide rod which consequently secures the carrier bracket to the glide rod.

According to a further aspect of the CVP sub-assembly, the carrier bracket can be manufactured by means of extrusion, additive manufacturing, or another production method. Based on economies of scale, any of these manufacturing methods can be used to produce the carrier brackets economically.

According to the present invention, a CVP assembly for mounting at least one CVP sub-assembly to a fuel cell or electrolyzer stack is described. The CVP assembly comprises the CVP sub-assembly, at least one glide rod for holding the carrier bracket of the CVP sub-assembly, wherein the at least one glide rod is guided through the at least one through-hole of the carrier bracket of the CVP sub-assembly, and at least one mounting bracket for holding the at least one glide rod and for fastening the CVP assembly to the stack.

In a fuel cell or electrolyzer application, the at least one glide rod allows each CVP unit to be simply and optimally aligned to the unit cells. The use of the glide rod also allows cell voltage measurements of varying stack lengths and at varying pick-up positions along the stacking length of the fuel cell or electrolyzer stack. Depending on the application needs, this approach allows every cell voltage to be measured near the ends of the stack, for example, while allowing varying number of cells to be skipped near the middle of the stack, for example.

Furthermore, the CVP assembly is easily adaptable to work with mechanical shock and vibration loads. Moreover, the CVP assembly can be simply and easily adaptable to different stack lengths and configurations, as dictated by power and/or space requirements, for example.

The pick-ups of the CVP unit can be easily aligned to the unit cells since the carrier bracket can be easily and precisely moved along the length of the glide rod and affixed in place. The cell voltage pick-up capability can easily be scaled to the needs of the application by the addition or removal of CVP sub-assemblies.

In one instance, the at least one glide rod can be stiff. In another instance, the at least one glide rod can be a non-rigid cable held under tension. Possible material choices for the at least one glide rod include, but not limited to, stainless steel, aluminium, carbon fiber, Kevlar^{®}, or any other metallic and/or non-metallic material. Materials can be surface coated or sheathed as required.

The glide rod stiffness can be engineered and strategically placed such that the contact force administered by the pick-ups to the unit cells is maximally uniform.

In one instance, the at least one glide rod may provide more robust holding of the carrier bracket by the addition of a textured surface formed by knurling, threading, chemical etching, abrasive blasting, etc. In this case, the carrier bracket can comprise a corresponding characteristic.

In another instance, the at least one glide rod may comprise a solid or hollow round cross-section, a solid or hollow rectangular cross-section, a solid or hollow angle cross-section, a solid or hollow "T" cross-section, or any other geometric shape. The cross-section can be selected depending on stiffness requirements.

According to a further aspect of the CVP assembly, the CVP assembly comprises retaining components and/or retaining elements for preventing translational motion of the at least one glide rod relative to at least one end of the stack. In one instance of the invention, at least one snap-ring retaining component can be provided at the at least one end of the glide rod such that the glide rod is constrained to the at least one mounting bracket.

In one instance, the at least one mounting bracket can comprise materials including, but not limited to, aluminium, thermoplastics, thermosets, composites, stainless steel. The mounting bracket is engineered to further reduce flexural deformation of the at least one glide rod.

In another instance, the aforementioned functions of the mounting bracket are directly integrated into the stack hardware, thereby eliminating the need of a separate mounting bracket.

In one instance of the invention, the CVP assembly can comprise a mechanism for automatic redistribution of multiple CVP sub-assemblies based on length variations of the stacks. The mechanism for automatic redistribution can comprise spring-like elements which can be arranged between the carrier brackets of the CVP sub-assemblies. The overall length can then be adjusted at a single point.

According to the present invention, a fuel cell or electrolyzer system is described. The fuel cell or electrolyzer system comprises at least one fuel cell or electrolyzer stack and at least one CVP assembly according to the invention.

A method for assembling one instance of the CVP assembly in which at least one mounting bracket exists is described. The method comprises the steps of mounting a CVP unit to a carrier bracket to form a CVP sub-assembly, securing the glide rods to the at least one mounting bracket using the snap-ring retaining components, and feeding the glide rods through the through-holes of the carrier bracket of the CVP sub-assembly. After the CVP assembly is assembled, the at least one mounting bracket is fastened to the fuel cell or electrolyzer stack hardware.

In another instance of the CVP assembly in which the functions of the mounting bracket are directly integrated into the stack hardware, a method for assembling the CVP assembly is described. The method comprises the steps of mounting a CVP unit to a carrier bracket to form a CVP sub-assembly, feeding the glide rods through the through-holes of the carrier bracket of the CVP sub-assembly, and assembling the glide rods into mounting elements of the fuel cell or electrolyzer stack hardware.

Further advantages, features, and details of one instance of the invention should be apparent from the following descriptions in which at least one embodiment of the invention is described in detail with references to the figures listed hereinbelow.

### List of Figures

- Fig. 1: a perspective view of a CVP assembly according to a possible embodiment of the invention,
- Fig. 2: a perspective exploded view of the CVP assembly of Fig. 1,
- Fig. 3: a perspective view of a CVP unit,
- Fig. 4: a perspective view of another possible CVP unit,
- Fig. 5: a perspective exploded view of a CVP sub-assembly according to an embodiment of the invention,
- Fig. 6: a back view of the CVP sub-assembly of Fig. 5,
- Fig. 7: a side view of a pick-up,
- Fig. 8: a side view of another possible pick-up,
- Fig. 9: a back perspective view of a PCB with a pick-up,
- Fig. 10: a front perspective view of the PCB with a pick-up of Fig. 9,
- Fig. 11: a back perspective view of a PCB with open-ended holes and with pick-ups,
- Fig. 12: a front view of a carrier bracket, and
- Fig. 13: a side view of the carrier bracket of Fig. 12.

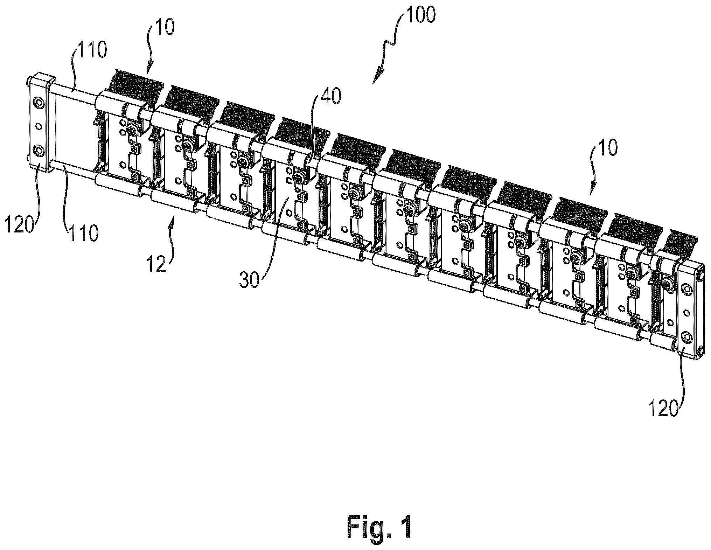

Fig. 1 shows a perspective view of a CVP assembly 100 according to a possible embodiment of the invention. With the CVP assembly 100, at least one CVP sub-assembly 12 can be mounted to a fuel cell or electrolyzer stack. As can be seen in Fig. 1, the CVP assembly 100 can comprise multiple CVP sub-assemblies 12, two glide rods 110, and two mounting brackets 120.

The carrier brackets 30 are mounted to the glide rods 110. As shown in Fig. 1, the glide rods 110 are guided through the through-holes 40 of the carrier brackets 30 of the CVP sub-assembly 12.

The two mounting brackets 120 are used to mount the glide rods 110 to the fuel cell or electrolyzer stack.

The CVP assembly 100 and the fuel cell or electrolyzer stack can be part of a fuel cell or an electrolyzer system.

The CVP assembly 100 allows easy adjustability, scalability, and improved robustness to harsh environments compared to existing state-of-the-art. The glide rods 110 allow each CVP sub-assembly 12 to be simply and optimally aligned to the one or more unit cells of the fuel cell or electrolyzer stack; this allows cell voltage measurement of varying stack lengths and at varying pick-up positions along the stacking length of the fuel cell or electrolyzer stack. The cell voltage pick-up capability can easily be scaled to the needs of the application by the addition or removal of CVP sub-assemblies 12. Moreover, the CVP assembly 100 can easily be adapted to work in environments where significant mechanical shock and vibration loads are present.

The CVP assembly 100 can comprise a mechanism for automatic redistribution of the CVP sub-assembly 12 based on length variations of the stacks. The mechanism for automatic redistribution can comprise spring-like elements which can be arranged between the CVP sub-assemblies 12, and preferably, between the carrier brackets 30 of the sub-assemblies 12.

In one embodiment of the invention, the at least one glide rod 110 is a rigid component. In another embodiment of the invention, the at least one glide rod 110 is a non-rigid component, such as a cable, held under tension. Possible material choices for the glide rod 110 include, but not limited to, stainless steel, aluminium, carbon fiber, Kevlar^{®}, or any other metallic and/or non-metallic material. Materials can be surface coated or sheathed as required for electrical safety, for example.

The stiffness of the glide rods 110 and the stiffness of the pick-ups 50 is engineered such that the contact force administered by the pick-ups 50 to the unit cells is maximally uniform and within the allowable range of the contact pressures.

In mechanically harsh applications, the glide rods 110 can be made to provide more robust holding of the carrier brackets 30 by the addition of a textured surface formed by knurling, threading, chemical etching, abrasive blasting, for example. The through-holes 40 of the carrier brackets 30 can comprise a corresponding characteristic, if necessary.

The glide rods 110 can comprise any geometric shape, solid or hollow, including but not limited to a round cross-section, rectangular cross-section, angular cross-section, or "T" cross-section. Different cross-sections of the glide rods 110 can be selected depending on stiffness requirements.

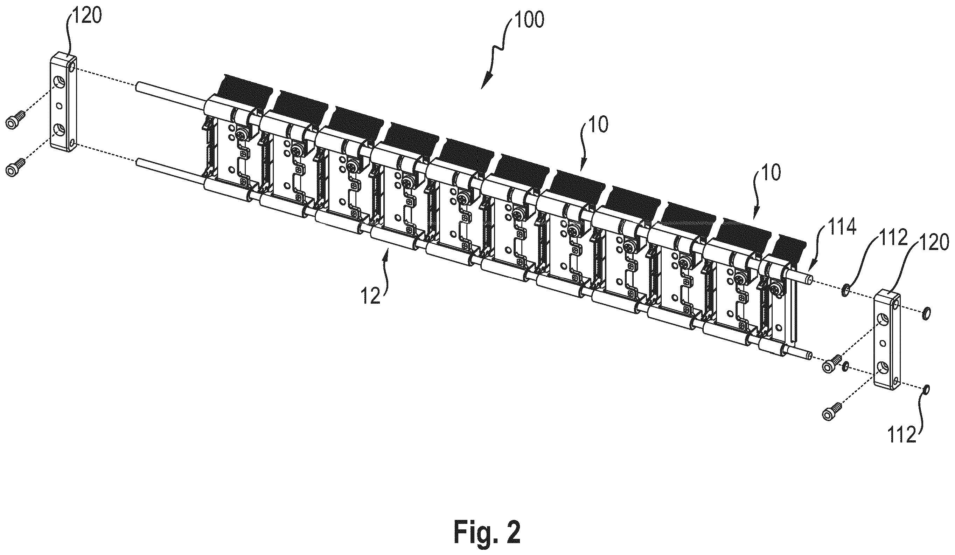

Fig. 2 shows a perspective exploded view of the CVP assembly 100 of Fig. 1. As can be seen in Fig. 2, the CVP assembly 100 can comprise retaining components 112 for preventing translational motion of the glide rods 110 relative to at least one of the mounting brackets 120. For each glide rod 110, a snap-ring retaining element 114 can be arranged on both sides of one of the mounting brackets 120 as shown in Fig. 2.

The mounting brackets 120 can comprise materials including, but not limited to, aluminium, thermoplastics, thermosets, composites, or stainless steel. The one or more mounting brackets 120 are engineered to further reduce flexural deformation of the glide rods 110.

In one instance of the invention, the functions of the mounting bracket 120 can be directly integrated into the stack hardware, thereby eliminating the need for one or more separate mounting brackets 120.

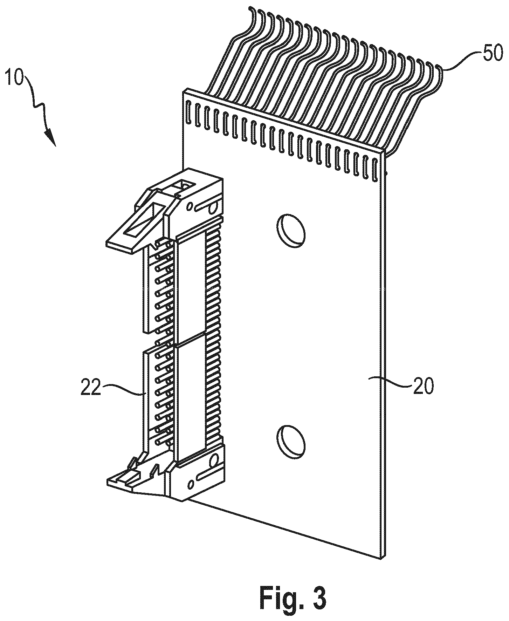

Fig. 3 shows a perspective view of a CVP unit 10. The CVP unit 10 comprises a PCB 20, pick-ups 50, and an electrical connector 22. The pick-ups 50 electrically connect the unit cells of the stack to the circuit of the PCB 20 which, in turn, electrically connects to the electrical connector 22. This allows voltages of individual cells or groups of cells to be conveyed to a CVM system.

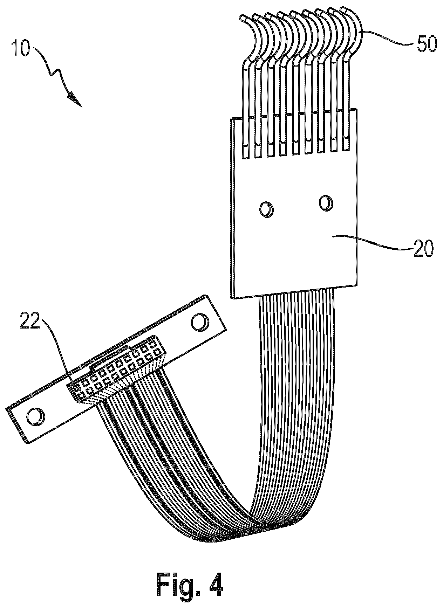

Another instance, as shown in Fig. 4, is the rigid-flex circuit board where the electrical connector 22 has been eliminated from the rigid portion of the CVP unit 10 and relocated to the end of the flexible portion of the circuit board. This instance greatly improves the robustness of the CVP unit 10 in environmentally and mechanically harsh environments.

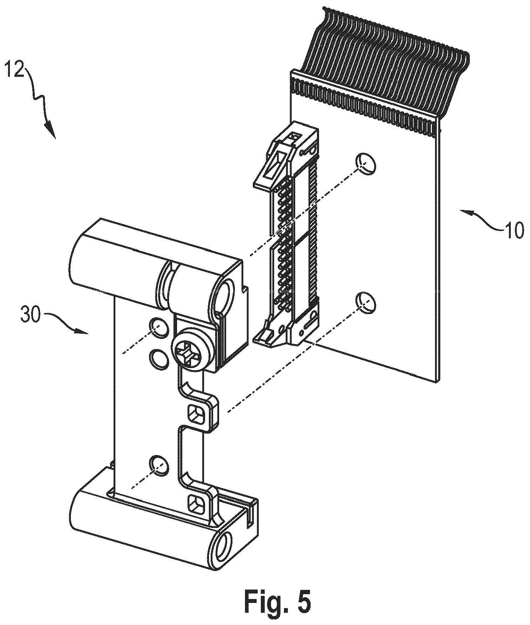

Fig. 5 shows a perspective exploded view of a CVP sub-assembly 12 according to one embodiment of the invention. The CVP sub-assembly 12 comprises a CVP unit 10 (for example as shown in Figs. 3 and 4) and a carrier bracket 30.

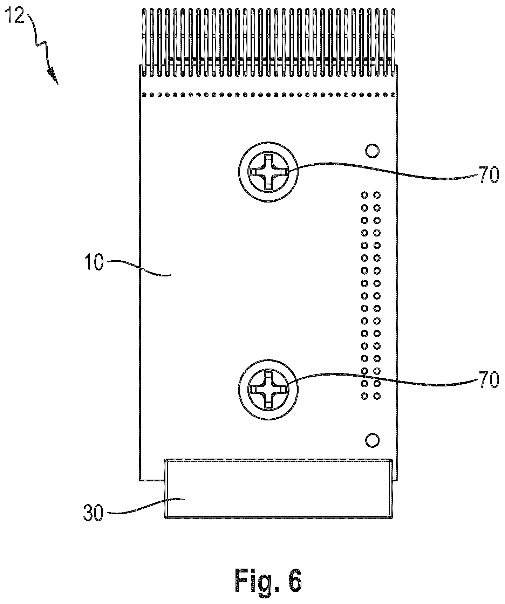

Fig. 6 shows a back view of a CVP sub-assembly 12 of Fig 5. As shown in Fig. 6, the CVP sub-assembly 12 comprises a CVP unit 10, a carrier bracket 30, and two affixing screws 34.

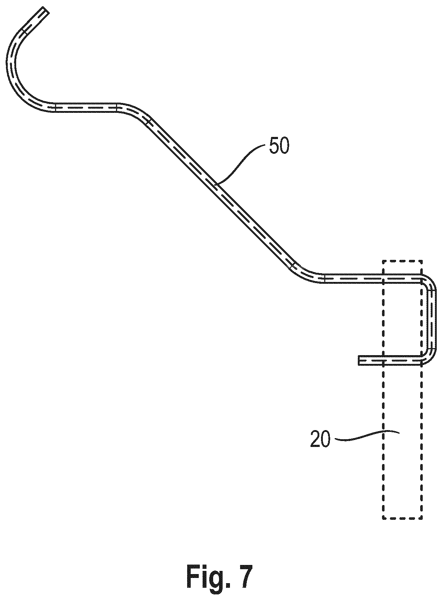

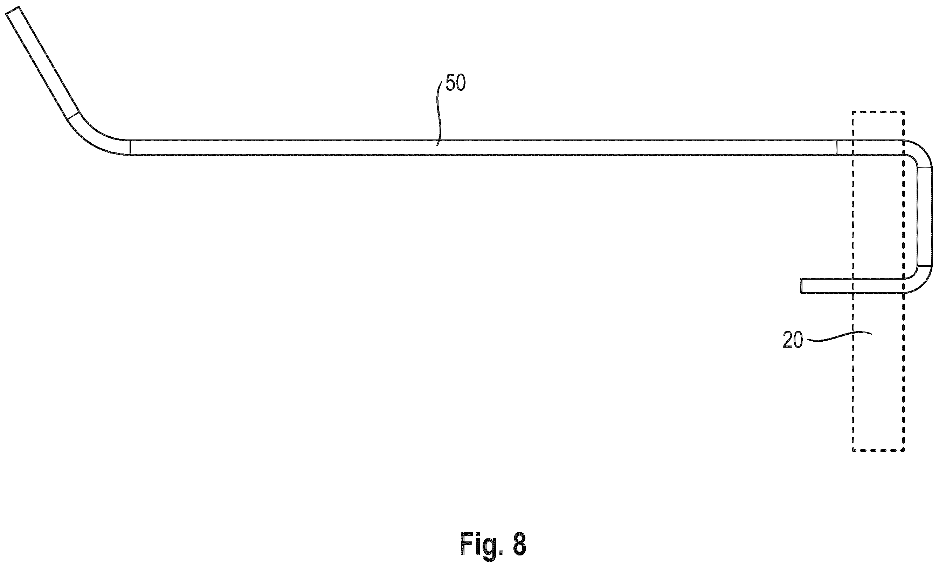

Fig. 7 and 8 show side views of two possible pick-ups 50, although many other geometries are possible. The pick-up 50 can be designed to suit any application and to allow the CVP sub-assembly 12 to mount to the fuel cell or electrolyzer stack in different orientations and positions. The pick-up 50 is designed to compensate for stack length changes arising from compression set of seals and gas diffusion layers, cell-to-cell variations, and/or stack configuration based on power and/or space requirements, for example. The pick-up 50 can be based on a flexible spring wire.

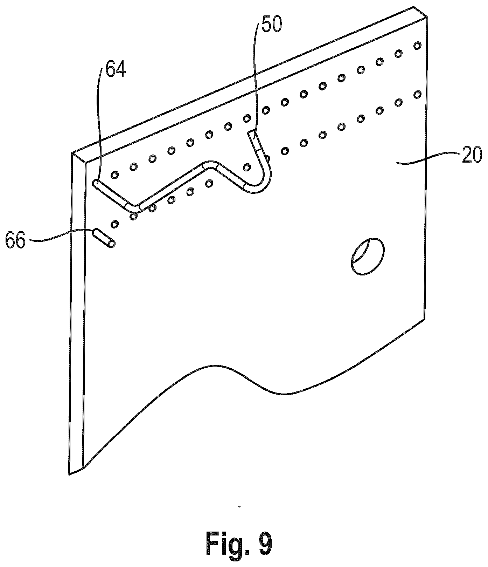

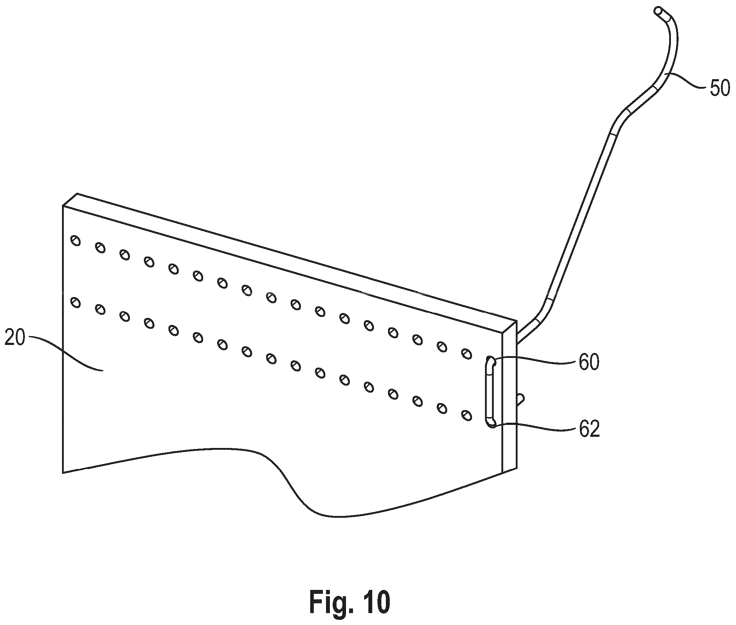

Fig. 9 shows a partial back perspective view of a PCB 20 with one pick-up 50 inserted. Fig. 10 shows a partial front perspective view of the same PCB 20 with the one pick-up 50 inserted. In this instance, the pick-up 50 is looped through two adjacent holes of the PCB 20 for optimal geometric alignment, and after soldering, to provide a secure electromechanical connection and for maximal robustness against mechanical loading and fatigue.

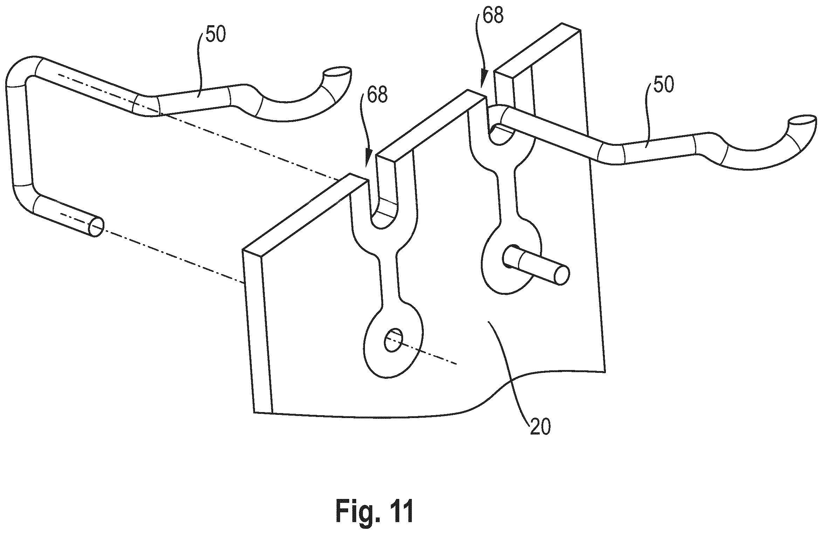

In another instance, Fig. 11 shows a PCB 20 with an open-ended hole 68 for each pick-up 50. In this instance, each pick-up 50 can simply be placed into position without the need for articulation. This is ideally suited for automated machine assembly using pick-and-place methodology.

Preferably, the pick-up 50 is soldered to the PCB 20 at four locations 60, 62, 64, 66 to further maximize robustness against mechanical loading and fatigue. The first soldering location 60 and second soldering location 62 can be the areas where the at least one pick-up 50 intersects with the front side of the PCB 20. The third soldering location 64 and fourth soldering location 66 can be the areas where the at least one pick-up intersects the back side of the PCB 20.

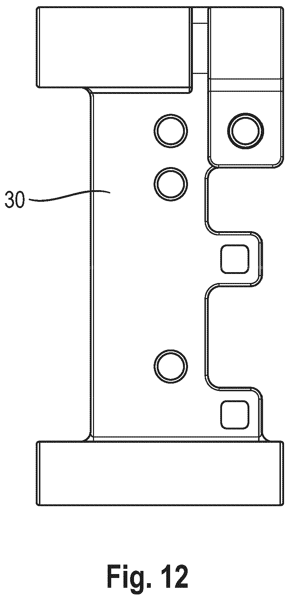

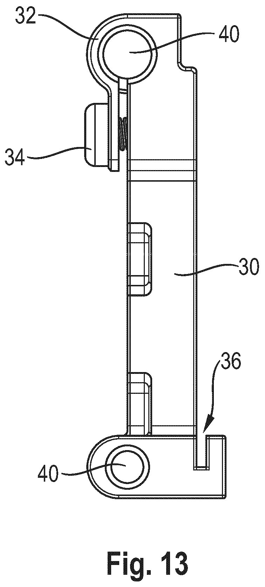

Fig. 12 and Fig. 13 respectively show the front and side views of the carrier bracket 30. As shown in Fig. 13, the carrier bracket 30 can comprise a slot 36 to retain the CVP unit 10. The carrier bracket 30 can comprise through-holes 40 for mounting to the glide rods 110.

As shown in Fig. 13, the carrier bracket 30 can comprise a retaining mechanism 32 for retaining the position of the carrier bracket 30 to the glide rods 110. In one instance, the retaining mechanism 32 can comprise a screw 34. With the tightening of the screw 34, the diameter of the through-hole 40 can be reduced, thereby securing the carrier bracket 30 to the glide rod 110.

In another instance, the retaining mechanism 32 can comprise a spring-loaded lever that interlocks with elements of the glide rod 110 to secure the carrier bracket 30 to the glide rod 110.

In another instance, the retaining mechanism 32 comprises a spring-loaded mechanism that applies frictional force to secure the carrier bracket 30 to the glide rod 110.

The carrier bracket 30 can be manufactured by means of extrusion, additive manufacturing, moulding, machining, or any other production method; based on economies of scale, any of these manufacturing methods can be used to produce the carrier brackets 30 economically.

The figures and the descriptions of those figures hereinabove describe the present invention by way of example only. The invention is not limited by the embodiments as described hereinabove.

### Label References

- 10: cell voltage pickup unit (CVP unit)
- 12: cell voltage pickup sub-assembly (CVP sub-assembly)
- 20: printed circuit board (PCB)
- 22: electrical connector
- 30: carrier bracket
- 32: retaining mechanism
- 34: screw
- 36: slot
- 40: through-hole
- 50: pick-up
- 60: first soldering location
- 62: second soldering location
- 64: third soldering location
- 66: fourth soldering location
- 68: open-ended hole
- 70: affixing screw

- 100: cell voltage pickup assembly (CVP assembly)
- 110: glide rod
- 112: retaining component
- 114: retaining element
- 120: mounting bracket

## Claims

1. Cell voltage pickup sub-assembly (12) for conveying voltages of unit cells to a cell voltage monitoring system, **characterized by**
a printed circuit board (20) for conducting electricity,
a carrier bracket (30) for holding the printed circuit board (20), wherein the carrier bracket (30) comprises at least one through hole (40) for mounting to a glide rod (110), and
at least one pick-up (50) for electrically connecting one of the unit cells and the printed circuit board (20).

2. Cell voltage pickup sub-assembly (12) according to claim 1, **characterized in that** the at least one pick-up (50) is looped through two different holes of the printed circuit board (20) to maximize robustness against mechanical loading.

3. Cell voltage pickup sub-assembly (12) according to claim 2, **characterized in that** the at least one pick-up (50) is soldered to the printed circuit board (20) using four soldering points to maximize robustness against mechanical loading.

4. Cell voltage pickup sub-assembly (12) according to any of the preceding claims, **characterized in that** the carrier bracket (30) comprises a retaining mechanism (32) for retaining a position of the carrier bracket (30) with respect to the glide rod (110).

5. Cell voltage pickup sub-assembly (12) according to any of the preceding claims, **characterized in that** the carrier bracket (30) is manufactured by means of extrusion or 3D printing.

6. Cell voltage pickup sub-assembly (12) according to any of the preceding claims, **characterized in that** the at least one through hole (40) of the carrier bracket (30) comprises a textured surface for increasing the friction between the glide rod (110) and the carrier bracket (30).

7. Cell voltage pickup sub-assembly (12) according to any of the preceding claims, **characterized in that** the printed circuit board (20) is a rigid-flex printed circuit board.

8. Cell voltage pickup assembly (100) for mounting at least one cell voltage pickup sub-assembly (12) according to any of claims 1 to 7 to a fuel cell or electrolyzer stack, **characterized by**
the at least one cell voltage pickup sub-assembly (12),
at least one glide rod (110) for holding the carrier bracket (30) of the at least one cell voltage pickup sub-assembly (12), wherein the at least one glide rod (110) is guided through at least one through hole (40) of the carrier bracket (30), and
two mounting brackets (120) for holding the at least one glide rod (110) and for fastening the cell voltage pickup assembly (100) to the fuel cell or electrolyzer stack.

9. Cell voltage pickup assembly (100) according to claim 8, **characterized in that** the at least one glide rod (110) comprises a textured surface.

10. Cell voltage pickup assembly (100) according to claim 8 or 9, **characterized in that** the at least one glide rod (110) comprises a solid or hollow round cross-section, a solid or hollow rectangular cross-section, a solid or hollow angle cross-section or a solid or hollow "T" cross-section.

11. Cell voltage pickup assembly (100) according to any of claims 8 to 10, **characterized in that** the cell voltage pickup system (100) comprises retaining components (112) for preventing a translational motion of the at least one glide rod (110).

12. Cell voltage pickup assembly (100) according to any of claims 8 to 11, **characterized in that** the two mounting brackets (120) comprise aluminium, thermoplastics, thermosets, composites, and/or stainless steel.

13. Cell voltage pickup assembly (100) according to any of claims 8 to 12, **characterized in that** the cell voltage pickup assembly (100) comprises several cell voltage pickup sub-assemblies (12) and a mechanism for automatic redistribution of the carrier brackets (30) of the several cell voltage pickup sub-assemblies (12) based on cell-to-cell length variations of the fuel cell or electrolyzer stack.

14. Fuel cell or electrolyzer system, **characterized by** at least one fuel cell or electrolyzer stack and at least one cell voltage pickup assembly (100) according to any of claims 8 to 13.

## Patentansprüche

1. Teilbaugruppe zur Zellspannungsabnahme (12) zur Übertragung der Spannungen von Einzelzellen an ein Zellspannungsüberwachungssystem, **gekennzeichnet durch**:
eine Leiterplatte (20) zur elektrischen Leitung,
eine Trägerhalterung (30) zur Aufnahme der Leiterplatte (20), wobei die Trägerhalterung (30) mindestens eine Durchgangsbohrung (40) zur Befestigung an einer Gleitstange (110) aufweist, und
mindestens einen Abtaster (50) zur elektrischen Verbindung einer der Einzelzellen mit der Leiterplatte (20).

2. Teilbaugruppe zur Zellspannungsabnahme (12) nach Anspruch 1, **dadurch gekennzeichnet, dass** der mindestens eine Abtaster (50) durch zwei verschiedene Bohrungen der Leiterplatte (20) geführt ist, um die Robustheit gegenüber mechanischer Belastung zu maximieren.

3. Teilbaugruppe zur Zellspannungsabnahme (12) nach Anspruch 2, **dadurch gekennzeichnet, dass** der mindestens eine Abtaster (50) mit vier Lötpunkten auf die Leiterplatte (20) gelötet ist, um die Robustheit gegenüber mechanischer Belastung zu maximieren.

4. Teilbaugruppe zur Zellspannungsabnahme (12) nach einem der vorhergehenden Ansprüche, **dadurch gekennzeichnet, dass** die Trägerhalterung (30) einen Haltemechanismus (32) zur Fixierung der Trägerhalterung (30) relativ zur Gleitstange (110) aufweist.

5. Teilbaugruppe zur Zellspannungsabnahme (12) nach einem der vorhergehenden Ansprüche, **dadurch gekennzeichnet, dass** die Trägerhalterung (30) durch Extrusion oder 3D-Druck hergestellt ist.

6. Teilbaugruppe zur Zellspannungsabnahme (12) nach einem der vorhergehenden Ansprüche, **dadurch gekennzeichnet, dass** die mindestens eine Durchgangsbohrung (40) der Trägerhalterung (30) eine strukturierte Oberfläche aufweist, um die Reibung zwischen der Gleitstange (110) und der Trägerhalterung (30) zu erhöhen.

7. Teilbaugruppe zur Zellspannungsabnahme (12) nach einem der vorhergehenden Ansprüche, **dadurch gekennzeichnet, dass** die Leiterplatte (20) eine starr-flexible Leiterplatte ist.

8. Zellspannungsabnahmeeinheit (100) zur Montage mindestens einer Teilbaugruppe zur Zellspannungsabnahme (12) gemäß einem der Ansprüche 1 bis 7 an einem Brennstoffzellen- oder Elektrolyseurstapel, **gekennzeichnet durch**:
die mindestens eine Teilbaugruppe zur Zellspannungsabnahme (12),
mindestens eine Gleitstange (110) zur Aufnahme der Trägerhalterung (30) der mindestens eine Teilbaugruppe zur Zellspannungsabnahme (12), wobei die mindestens eine Gleitstange (110) durch mindestens eine Durchgangsbohrung (40) der Trägerhalterung (30) geführt wird, und
zwei Montagehalterungen (120) zur Aufnahme der mindestens einen Gleitstange (110) und zur Befestigung der Zellspannungsaufnahmeeinheit (100) am Brennstoffzellen- oder Elektrolyseurstapel.

9. Zellspannungsabnahmeeinheit (100) nach Anspruch 8, **dadurch gekennzeichnet, dass** die mindestens eine Gleitstange (110) eine strukturierte Oberfläche aufweist.

10. Zellspannungsabnahmeeinheit (100) nach Anspruch 8 oder 9, **dadurch gekennzeichnet, dass** die mindestens eine Gleitstange (110) einen massiven oder hohlen runden Querschnitt, einen massiven oder hohlen rechteckigen Querschnitt, einen massiven oder hohlen Winkelquerschnitt oder einen massiven oder hohlen T-Querschnitt aufweist.

11. Zellspannungsabnahmeeinheit (100) nach einem der Ansprüche 8 bis 10, **dadurch gekennzeichnet, dass** das Zellspannungsaufnahmesystem (100) Halteelemente (112) zur Verhinderung einer translatorischen Bewegung der mindestens einen Gleitstange (110) aufweist.

12. Zellspannungsabnahmeeinheit (100) nach einem der Ansprüche 8 bis 11, **dadurch gekennzeichnet, dass** die beiden Montagehalterungen (120) aus Aluminium, Thermoplasten, Duroplasten, Verbundwerkstoffen und/oder Edelstahl bestehen.

13. Zellspannungsabnahmeeinheit (100) nach einem der Ansprüche 8 bis 12, **dadurch gekennzeichnet, dass** der Zellenspannungsabnehmer (100) mehrere Teilbaugruppen zur Zellspannungsabnahme (12) und einen Mechanismus zur automatischen Umverteilung der Trägerhalterungen (30) der einzelnen Teilbaugruppen zur Zellspannungsabnahme (12) basierend auf den Längenunterschieden der einzelnen Zellen des Brennstoffzellenoder Elektrolyseurstapels umfasst.

14. Brennstoffzellen- oder Elektrolyseursystem, **gekennzeichnet durch** mindestens einen Brennstoffzellen- oder Elektrolyseurstapel und mindestens eine Zellspannungsabnahmeeinheit (100) gemäß einem der Ansprüche 8 bis 13.

## Revendications

1. Sous-ensemble de prise de tension de cellule (12) pour la transmission des tensions de cellules individuelles à un système de surveillance de la tension cellulaire, **caractérisé par** :
une carte de circuit imprimé (20) pour la conduction électrique,
un support (30) destiné à recevoir la carte de circuit imprimé (20), ce support (30) comportant au moins un trou traversant (40) pour la fixation à une tige coulissante (110), et
au moins un capteur (50) pour la connexion électrique d'une cellule individuelle à la carte de circuit imprimé (20).

2. Sous-ensemble de prise de tension de cellule (12) selon la revendication 1, **caractérisé en ce que** le capteur (50) est guidé à travers deux trous différents de la carte de circuit imprimé (20) afin d'optimiser sa résistance aux contraintes mécaniques.

3. Sous-ensemble de prise de tension de cellule (12) selon la revendication 2, **caractérisé en ce que** le capteur (50) est soudé à la carte de circuit imprimé (20) par quatre points de soudure afin d'optimiser sa résistance aux contraintes mécaniques.

4. Sous-ensemble de prise de tension de cellule (12) selon l'une quelconque des revendications précédentes, **caractérisé en ce que** le support (30) comporte un mécanisme de retenue (32) permettant de le fixer par rapport à la tige coulissante (110).

5. Sous-ensemble de prise de tension de cellule (12) selon l'une quelconque des revendications précédentes, **caractérisé en ce que** le support (30) est fabriqué par extrusion ou impression 3D.

6. Sous-ensemble de prise de tension de cellule (12) selon l'une quelconque des revendications précédentes, **caractérisé en ce que** l'au moins un trou traversant (40) du support (30) présente une surface structurée afin d'accroître le frottement entre la tige coulissante (110) et le support (30).

7. Sous-ensemble de prise de tension de cellule (12) selon l'une quelconque des revendications précédentes, **caractérisé en ce que** le circuit imprimé (20) est un circuit imprimé rigide-flexible.

8. Unité de prise de tension de cellule (100) destinée au montage d'au moins un sous-ensemble de prise de tension de cellule (12) selon l'une quelconque des revendications 1 à 7 sur une pile à combustible ou un empilement d'électrolyseurs, **caractérisée par** :
le sous-ensemble de prise de tension de cellule (12) ;
au moins une tige coulissante (110) destinée à recevoir le support (30) de sous-ensemble de prise de tension de cellule (12), ladite tige coulissante (110) étant guidée à travers au moins un trou traversant (40) du support (30) ; et
deux supports de montage (120) destinés à recevoir la tige coulissante (110) et à fixer l'unité de réception de tension de cellule (100) à la pile à combustible ou à l'empilement d'électrolyseurs.

9. Unité de prise de tension de cellule (100) selon la revendication 8, **caractérisée en ce que** la tige coulissante (110) présente une surface structurée.

10. Unité de prise de tension de cellule (100) selon la revendication 8 ou 9, **caractérisée en ce que** la ou les tiges coulissantes (110) présentent une section transversale ronde pleine ou creuse, une section transversale rectangulaire pleine ou creuse, une section transversale angulaire pleine ou creuse, ou une section transversale en T pleine ou creuse.

11. Unité de prise de tension de cellule (100) selon l'une quelconque des revendications 8 à 10, **caractérisée en ce que** le système de réception de tension de cellule (100) comporte des éléments de retenue (112) empêchant le déplacement de translation de la ou des tiges coulissantes (110).

12. Unité de prise de tension de cellule (100) selon l'une quelconque des revendications 8 à 11, **caractérisé en ce que** les deux supports de montage (120) sont en aluminium, en thermoplastique, en thermodurcissable, en matériau composite et/ou en acier inoxydable.

13. Unité de prise de tension de cellule (100) selon l'une quelconque des revendications 8 à 12, **caractérisé en ce qu'**il comprend plusieurs sous-ensembles de prise de tension de cellule (12) et un mécanisme de redistribution automatique des supports (30) de ces sous-ensembles de prise de tension de cellule (12) en fonction des différences de longueur des cellules de la pile à combustible ou de l'électrolyseur.

14. Système de pile à combustible ou d'électrolyseur, **caractérisé par** au moins une pile à combustible ou un électrolyseur et au moins une unité de prise de tension de cellule (100) selon l'une quelconque des revendications 8 à 13.
